# EUROPÄISCHE PATENTSCHRIFT

(11) **EP 3 205 746 B1**
(45) Veröffentlichungstag und Bekanntmachung des Hinweises auf die Patenterteilung: **17.05.2023**
(21) Anmeldenummer: 16204240.2
(22) Anmeldetag: 15.12.2016
(51) Int. Cl.: C23C 28/00, C23C 4/18, C23C 4/11

(54) **WÄRMEDÄMMSCHICHT MIT HOHEM KORROSIONSWIDERSTAND**
THERMAL BARRIER COATING SYSTEM WITH HIGH CORROSION RESISTANCE
SYSTÈME DE REVÊTEMENT DE BARRIÈRE THERMIQUE À RÉSISTANCE À LA CORROSION ÉLEVÉE

(30) Priorität: 10.02.2016 DE 102016201947
(43) Veröffentlichungstag der Anmeldung: 16.08.2017
(73) Patentinhaber: MTU Aero Engines AG, 80995 München (DE)
(72) Erfinder: Döbber, Philipp, 30161 Hannover (DE); Seidel, Frank, 30938 Grossburgwedel (DE)

(56) Entgegenhaltungen:
- EP-A1- 2 233 450
- US-A- 5 683 761
- US-A1- 2009 169 914
- US-A1- 2015 064 430
- CHEN X ET AL: "Thermal cycling failure of new LaMgAl11O19/YSZ double ceramic top coat thermal barrier coating systems", SURFACE AND COATINGS TECHNOLOGY, ELSEVIER BV, AMSTERDAM, NL, Bd. 205, Nr. 10, 15. Februar 2011 (2011-02-15), Seiten 3293-3300, XP027586620, ISSN: 0257-8972 [gefunden am 2011-01-06]

## Beschreibung

### HINTERGRUND DER ERFINDUNG

### GEBIET DER ERFINDUNG

Die vorliegende Erfindung betrifft ein Bauteil einer Strömungsmaschine mit einem Wärmedämmschichtsystem sowie ein Verfahren zur Herstellung eines Wärmedämmschichtsystems auf metallische Bauteile einer Strömungsmaschine, insbesondere für hochtemperaturbelastete oder heißgasbelastete Bauteile einer Strömungsmaschine bzw. eines Flugtriebwerks.

### STAND DER TECHNIK

Strömungsmaschinen wie stationäre Gasturbinen oder Flugtriebwerke werden zur Steigerung des Wirkungsgrades bei möglichst hohen Temperaturen betrieben, wobei die in heißen Bereichen der Strömungsmaschine, wie Brennkammer oder Hochdruckturbine, eingesetzten Bauteile, wie Leit- oder Laufschaufeln häufig auch zusätzlich eine hohe mechanische Festigkeit aufweisen müssen. Um dies zu erreichen werden die metallischen Bauteile einerseits gekühlt und andererseits mit Wärmedämmschichten versehen, um die effektiven Betriebstemperaturen für die verwendeten metallischen Werkstoffe niedrig zu halten.

Als Wärmedämmschichten werden Keramikschichten, wie beispielsweise Schichten aus Yttrium - stabilisiertem Zirkonoxid eingesetzt, die häufig auf einer Haftvermittlerschicht der Zusammensetzung MCrAlY mit M gleich Fe, Ni und/oder Co aufgebracht sind, wobei die Haftvermittlerschicht nicht nur die gute Haftung der Keramikschicht an dem metallischen Substrat bzw. Bauteil bewirkt, sondern zusätzlich auch eine Oxidationsschutzwirkung aufweist.

Insbesondere bei Flugtriebwerken, die häufig in Gegenden betrieben werden, in denen sich viel Staub oder Sandpartikel in der Luft befinden, wie beispielsweise Wüstengegenden oder dergleichen, tritt jedoch das Problem auf, dass die eingesaugten Staub- und Sandpartikel in der Brennkammer aufschmelzen und in die Wärmedämmschichten entlang offener Poren oder Mikrorisse eindringen. Dies führt dazu, dass innerhalb der Beschichtung Spannungen aufgebaut werden, die zu einem Versagen der Wärmedämmschicht und bei einem Verlust der Wärmedämmschicht auch zu einem Bauteilversagen führen können. Die Sandpartikel oder Staubpartikel werden häufig als CMAS - Verunreinigungen bezeichnet, wobei CMAS für Calcium, Magnesium, Aluminium und deren Oxide sowie Silikate steht.

Zur Vermeidung derartiger Schädigungen von Wärmedämmschichten sind bereits Vorschläge gemacht worden, die unter anderem das Vorsehen einer äußeren Opferoxidschicht (siehe US 5 660 885 A) und insbesondere einer äußeren Aluminiumoxidschicht auf einer Wärmedämm-schicht umfassen (siehe US 2011/0151219 A1). Allerdings verändern derartige Deckoxidschichten die mechanischen Eigenschaften des Schichtsystems, sodass auf Grund unterschiedlicher Wärmeausdehnungskoeffizienten Spannungen im Schichtsystem entstehen können, die ebenfalls zu einem Versagen der Beschichtung führen können. Auch durch die zunehmende Dicke des Gesamtschichtsystems kann es zu ungünstigen mechanischen Eigenschaften des Schichtsystems kommen. So führt bei reinen Aluminiumoxidschichten als Deck- oder Opferoxidschicht, wie in der US 2011/0151219 A1 vorgeschlagen, die geringe Wärmeausdehnung der Aluminiumoxidschicht zu Spannungen innerhalb des Schichtverbundes, sodass durch diese Spannungen ein Schichtversagen verursacht werden kann. Entsprechend ist in dem Dokument US 2011/0151132 A1 auch vorgeschlagen worden, neben dem Aluminiumoxid in der Deckschicht Titandioxid vorzusehen. Aus der Veröffentlichung "Thermal cycling failure of new LaMgAl11O19/YSZ double ceramic top coat thermal barrier coating systems", Xiaolong Chen, Surface & Coatings Technology 205 (2011) 3293 - 3300, ist ein Schichtsystem zur thermischen Abschirmung von Turbinenkomponenten bekannt, welches eine Haftschicht, eine Yttriumoxid stabilisierte Zirkonoxidschicht (YSZ-Schicht) sowie eine LaMgAlO-Schicht aufweist. Letztere weist Al₂O₃ in der γ-Modifikation auf. Die Patentschrift US 5,683,761 A offenbart ein Schichtsystem zur thermischen Abschirmung von Turbinenkomponenten, welches eine Schicht mit α-Al₂O₃ aufweist. Diese Schicht wird direkt auf eine metallische Haftschicht oder auf eine YSZ-Schicht, die wiederum auf einer metallischen Haftschicht angeordnet ist, aufgetragen, wobei jedoch nur bezüglich der erstgenannten Schichtstruktur offenbart ist, dass die α -Al₂O₃-Schicht weitere keramische Bestandteile wie Magnesiumoxid umfasst. Die Patentanmeldungsveröffentlichungen US 2015/0064430 A1, US 2009/0169914 A1 und EP 2233450 A1 beschreiben Schichtsysteme zur thermischen Abschirmung von Turbinenkomponenten, deren Deckschichten Al₂O₃ beinhalten, wobei keine Angaben zu der Modifikation des Al₂O₃ gemacht sind.

Insgesamt muss jedoch ein Kompromiss zwischen mechanischen Eigenschaften des Schichtsystems und dem Korrosionsschutz sowie weiteren Randbedingungen, wie Herstellbarkeit, Betriebszuverlässigkeit etc. gefunden werden. Dies führt dazu, dass für die gewünschte Verbesserung der Lebensdauer und Korrosionsbeständigkeit von Wärmedämmschichten, weitere Anstrengungen zur Verbesserung von Wärmedämmschichtsystemen erforderlich sind.

### OFFENBARUNG DER ERFINDUNG

### AUFGABE DER ERFINDUNG

Es ist deshalb Aufgabe der vorliegenden Erfindung ein Wärmedämmschichtsystem für metallische Bauteile einer Strömungsmaschine bereitzustellen, welches auch bei hochkorrosiven Bedingungen, wie insbesondere Umgebungsbedingungen mit hohem Staub- und Sandanteil eine hohe Lebensdauer aufweist. Die entsprechenden Maßnahmen hierfür sollen einfach durchführbar sein und das Eigenschaftsprofil der entsprechenden Bauteile nicht negativ beeinflussen.

### TECHNISCHE LÖSUNG

Diese Aufgabe wird gelöst mit einer Wärmedämmschicht mit den Merkmalen des Anspruchs 1 sowie einem Verfahren zur Herstellung eines entsprechenden Wärmedämmschichtsystems mit den Merkmalen des Anspruchs 6. Vorteilhafte Ausgestaltungen sind Gegenstand der abhängigen Ansprüche.

Die vorliegende Erfindung schlägt ein Bauteil einer Strömungsmaschine mit einem Wärmedämmschichtsystem mit einer Keramikschicht (4) aus voll - oder teilstabilisiertem Zirkonoxid und einer Oxiddeckschicht (5) auf der Keramikschicht (4) vor, wobei die Oxiddeckschicht Aluminiumoxid umfasst, wobei das Aluminiumoxid zumindest teilweise als freies α - Al2O3 vorliegt und die Oxiddeckschicht (5) mindestens 50 vol.-% α - Al2O3 umfasst, und wobei ein Oxidschichtsystem (4, 5) die Wärmedämm-schicht (4) aus Zirkonoxid und die Oxiddeckschicht (5) umfasst und wobei die Oxiddeckschicht (5) weiterhin Lanthan beinhaltet und die Oxiddeckschicht (5) eine Porosität von 5 bis 30 vol.-% aufweist.

Die Wärmedämmschicht ist mit einer Keramikschicht aus voll- oder teilstabilisiertem Zirkonoxid einer Oxiddeckschicht vorgesehen, die neben Aluminiumoxid mindestens ein Element aus der Gruppe umfasst, die Lanthan, Magnesium, Silicium, Calcium und Natrium beinhaltet, wobei zusätzlich das Aluminiumoxid zumindest teilweise als freies α - Aluminiumoxid vorliegt. Die chemischen Elemente Lanthan, Magnesium, Silicium, Calcium und Natrium liegen ebenso wie das Aluminium in oxidierter Form vor, wobei jedoch die Modifikation, in der das jeweilige Element vorliegt unterschiedlich sein kann. So können die Elemente in Form ihrer jeweiligen Oxide vorliegen und/oder als Aluminate oder vergleichbare komplexe Verbindungen. Eine derartige Wärmedämmschicht weist eine gute Korrosionsbeständigkeit gegenüber CMAS - Ablagerungen auf und besitzt weiterhin die erforderlichen mechanischen Eigenschaften, insbesondere für einen Temperaturwechselbetrieb, wie er bei Flugtriebwerken üblich ist, um eine hohe Lebensdauer zu garantieren. Durch das freie Aluminiumoxid, das in separaten Phasen mit Aluminiumoxidstruktur vorliegt und nicht in einer anderen Struktur mit den weiteren Bestandteilen der Oxidschicht eingebunden ist, wie z.B. Aluminate, insbesondere Lanthanhexaaluminat oder dergleichen, steht zumindest ein Teil des in der Oxiddeckschicht vorhandenen Aluminiumoxids unmittelbar zur Reaktion mit CMAS - Ablagerungen zur Verfügung und kann dadurch einen effektiven Korrosionsschutz bewirken. Unter "frei" wird somit in Bezug auf das Aluminiumoxid in der Oxiddeckschicht verstanden, dass das Aluminiumoxid als separate Phase mit Aluminiumoxidstruktur vorliegt. Zumindest ein Teil des Aluminiumoxids liegt in der α - Modifikation vor, die thermisch stabil ist, sodass Umwandlungen und damit einhergehende Volumenänderungen sowie daraus resultierende Spannungen während eines Temperaturwechselbetriebs vermieden werden können.

Die Oxiddeckschicht kann mindestens 50 vol.-%, vorzugsweise mindestens 60 vol.-%, insbesondere mindestens 90 vol.-% Aluminiumoxid umfassen, wobei das Aluminiumoxid sowohl als freies Aluminiumoxid als auch als Aluminiumoxid in einer Komplexstruktur, wie beispielsweise Lanthanhexaaluminat vorliegen kann. Darüber hinaus umfasst die Oxiddeckschicht mindestens 50 vol.-%, vorzugsweise mindestens 60 vol.-%, insbesondere 90 vol.-% α - Aluminiumoxid, welches thermisch stabil ist und somit keine Struktur - / Volumenänderung induziert, die zu unerwünschten mechanischen Spannungen in der Schicht führen könnten. Vorzugsweise liegt das gesamte freie Aluminiumoxid als α - Aluminiumoxid vor. Durch den Zusatz von Lanthan in die Oxiddeckschicht kann die Reaktionsneigung der Oxiddeckschicht mit den CMAS - Verunreinigungen zur Bildung hochschmelzender Partikel, die entsprechend an der Oberfläche kristallisieren und nicht in die Wärmedämmschicht infiltrieren, bei gleichzeitiger Verbesserung der mechanischen Eigenschaften des Schichtsystems gesteigert oder zumindest beibehalten werden.

Zur Vermeidung von Spannungen und somit zur Verbesserung der mechanischen Stabilität des Schichtsystems weist die Oxiddeckschicht eine Porosität von 5 vol.-% bis 30 vol.-%, insbesondere 10 vol.-% bis 25 vol.-% auf.

Weiterhin kann zur Begrenzung der auftretenden mechanischen Spannungen die Gesamtdicke des Oxidschichtsystems, das die Wärmedämmschicht aus Zirkonoxid und die Oxiddeckschicht umfasst, auf eine Schichtdicke von maximal 750 µm, vorzugsweise maximal 500 µm begrenzt werden, wobei insbesondere die Oxiddeckschicht eine Dicke im Bereich von 50 µm bis 250 µm aufweisen kann.

Das Wärmedämmschichtsystem kann zusätzlich eine Haftvermittler - und/oder Oxidationsschutzschicht umfassen, welche zwischen dem Substrat, auf dem das Wärmedämmschichtsystem aufgebracht wird, und der Keramikschicht als eigentlicher Wärmedämmschicht vorgesehen werden kann. Die Haftvermittler - und/oder Oxidationsschutzschicht kann insbesondere eine Alitierschicht mit oder ohne Zusatz von Platin oder eine MCrAlY-Schicht mit M aus Eisen, Nickel oder Kobalt sein.

Zur Herstellung eines entsprechenden Wärmedämmschichtsystems können sowohl die Keramikschicht aus Zirkonoxid als auch die Oxiddeckschicht durch thermisches Spritzen oder Elektronenstrahlverdampfen (Electron Beam Physical Vapor Deposition EB - PVD) aufgebracht werden. Zur Einstellung einer entsprechenden Porosität der Oxiddeckschicht können die Parameter bei der Schichtabscheidung entsprechend gewählt werden.

Zur Ausbildung der α - Modifikation des freien Aluminiumoxids in der Oxiddeckschicht kann die Wärmedämmschicht einer geeigneten Wärmebehandlung unterzogen werden, sodass das thermisch stabile α - Aluminiumoxid gebildet wird.

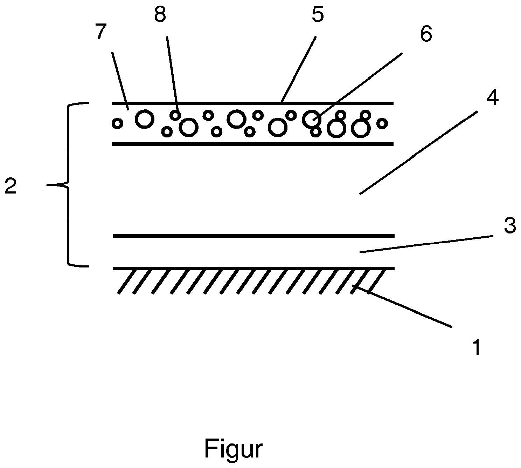

### KURZBESCHREIBUNG DER FIGUR

Die beigefügte Zeichnung zeigt in rein schematischer Weise eine Schnittansicht durch ein Ausführungsbeispiel eines erfindungsgemäßen Wärmedämmschichtsystems.

### AUSFÜHRUNGSBEISPIEL

Weitere Vorteile, Kennzeichen und Merkmale der vorliegenden Erfindung werden bei der nachfolgenden detaillierten Beschreibung eines Ausführungsbeispiels deutlich. Allerdings ist die Erfindung nicht auf dieses Ausführungsbeispiel beschränkt.

Die beigefügte Figur zeigt in einem Querschnitt ein Beispiel für ein erfindungsgemäßes Wärmedämmschichtsystem, welches auf einem Substrat 1 aufgebracht ist. Bei dem Substrat 1 kann es sich um ein metallisches Bauteil einer Strömungsmaschine, wie beispielsweise eines Flugtriebwerks handeln, welches aus einer Eisen -, Nickel - oder Kobaltbasislegierung gebildet ist oder aus anderen hochtemperaturbeständigen Materialien, wie beispielsweise Titanaluminid und Legierungen daraus oder hochtemperaturbeständigen Verbundwerkstoffen. Das Bauteil kann ein Bauteil aus einem hochtemperaturbelasteten oder heißgasbelasteten Bereich einer Strömungsmaschine sein, wie beispielsweise ein Bauteil der Brennkammer oder der Hochdruckturbine. Insbesondere kann es sich um Schaufeln wie Leitschaufeln oder Laufschaufeln der Hochdruckturbine eines Flugtriebwerks handeln.

Das gezeigte Wärmedämmschichtsystem 2 umfasst eine Haftvermittlerschicht 3, eine Wärmedämmschicht 4 in Form einer Keramikschicht und eine Oxiddeckschicht 5.

Die Haftvermittlerschicht 3, die gleichzeitig auch die Funktion einer Oxidationsschutzschicht aufweisen kann, kann beispielsweise durch eine sogenannte MCrAlY - Schicht gebildet sein, wobei M für Eisen, Kobalt und/oder Nickel steht. Alternativ kann es sich auch um eine Alitierschicht oder PtAl - Diffusionsschicht, also eine Alitierschicht mit Pt - Zusatz handeln, bei der in den Randbereich des Substrats 1 Aluminium oder Platin und Aluminium eindiffundiert werden.

Auf der Haftvermittlerschicht 3 ist die eigentliche Wärmedämmschicht 4 in Form einer Keramikschicht vorgesehen, die bei dem gezeigten Beispiel aus einer mit Yttriumoxid stabilisierten Zirkonoxidschicht gebildet ist.

Oberhalb der Keramikschicht 4 ist eine Oxiddeckschicht 5 ausgebildet, die Aluminium, Lanthan und Magnesium umfasst, wobei die entsprechenden Elemente in einem Aluminat, wie beispielsweise einem Lanthanhexaaluminat 7 vorliegen können, welches eine Matrix der Oxiddeckschicht 5 bildet. Zusätzlich sind freie Aluminiumoxidpartikel 6 in die Oxiddeckschicht 5 eingelagert. Darüber hinaus können auch freie Magnesiumoxidpartikel und/oder Lanthanoxidpartikel (nicht gezeigt) vorhanden sein.

Das in der Oxiddeckschicht 5 enthaltene Aluminiumoxid ist zumindest teilweise als α - Aluminiumoxid ausgebildet, wobei zumindest ein Teil oder vorzugsweise alle der freien Aluminiumoxidpartikel in der Modifikation des α - Aluminiumoxids vorliegen.

Der Volumenanteil des in der Oxiddeckschicht enthaltenen Aluminiumoxids, insbesondere α - Aluminiumoxids beträgt mindestens 60 Vol.-%.

Durch das Bereitstellen der α - Aluminiumoxidpartikel 6 in der Oxiddeckschicht 5 können die sogenannten CMAS - Partikel, die aufgrund der hohen Temperatur in geschmolzener Form auf die Oxiddeckschicht 5 gelangen, mit dem freien α - Aluminiumoxid zu einer höher schmelzenden Phase namens Anorthit reagieren, sodass ein Eindringen der CMAS - Verunreinigungen in die Wärmedämmschicht 4 vermieden wird. Dadurch kann eine Beschädigung bzw. Beeinträchtigung der Wärmedämmschicht 4 vermieden werden und die Lebensdauer und Korrosionsbeständigkeit des Wärmedämmschichtsystems 2 wird verbessert.

Zur Verbesserung der mechanischen Eigenschaften des Wärmedämmschichtsystems 2 und insbesondere der Oxiddeckschicht 5 sind in der Oxiddeckschicht Poren 8 ausgebildet. Obwohl die vorliegende Erfindung anhand des Ausführungsbeispiels detailliert beschrieben worden ist, wird der Schutzgegenstand der Erfindung durch die Ansprüche definiert.

### BEZUGSZEICHENLISTE

- 1: Substrat, Bauteil
- 2: Wärmedämmschichtsystem
- 3: Haftvermittler - und/oder Oxidationsschutzschicht
- 4: Wärmedämmschicht, Keramikschicht
- 5: Oxiddeckschicht
- 6: Aluminiumoxidpartikel
- 7: Lanthanhexaaluminat
- 8: Poren

## Patentansprüche

1. Bauteil einer Strömungsmaschine mit einem Wärmedämmschichtsystem mit einer Keramikschicht (4) aus voll - oder teilstabilisiertem Zirkonoxid und einer Oxiddeckschicht (5) auf der Keramikschicht (4), wobei die Oxiddeckschicht Aluminiumoxid umfasst, wobei das Aluminiumoxid zumindest teilweise als freies α - Al₂O₃ vorliegt und die Oxiddeckschicht (5) mindestens 50 vol.-% α - Al₂O₃ umfasst und wobei ein Oxidschichtsystem (4, 5) die Wärmedämmschicht (4) aus Zirkonoxid und die Oxiddeckschicht (5) umfasst,
**dadurch gekennzeichnet, dass**
die Oxiddeckschicht (5) weiterhin Lanthan beinhaltet und die Oxiddeckschicht (5) eine Porosität von 5 bis 30 vol.-% aufweist.

2. Bauteil nach Anspruch 1,
**dadurch gekennzeichnet, dass**
die Oxiddeckschicht (5) mindestens 60 vol.-%, insbesondere mindestens 90 vol.-% α - Al₂O₃ umfasst.

3. Bauteil nach einem der vorhergehenden Ansprüche,
**dadurch gekennzeichnet, dass**
die Oxiddeckschicht (5) eine Porosität von 10 bis 25 vol.-% aufweist.

4. Bauteil nach einem der vorhergehenden Ansprüche,
**dadurch gekennzeichnet, dass**
das Wärmedämmschichtsystem (2) an der von der Oxiddeckschicht (5) abgewandten Seite der Keramikschicht (4) eine Haftvermittler - und/oder Oxidationsschutzschicht (3) aufweist.

5. Bauteil nach einem der vorhergehenden Ansprüche,
**dadurch gekennzeichnet, dass**
das Oxidschichtsystem (4, 5) eine Schichtdicke von maximal 750 µm, vorzugsweise maximal 500 µm aufweist, wobei insbesondere die Oxiddeckschicht (5) eine Dicke im Bereich von 50 µm bis 250 µm aufweist.

6. Verfahren zur Herstellung eines Wärmedämmschichtsystems auf ein Bauteil einer Strömungsmaschine, bei welchem eine Keramikschicht (4) aus voll - oder teilstabilisiertem Zirkonoxid mittels thermischem Spritzen oder Elektronenstrahlverdampfen auf einem Substrat (1) oder einer Haftvermittlerschicht (3) aufgebracht wird, wobei anschließend auf der Keramikschicht (4) mittels thermischem Spritzen oder Elektronenstrahlverdampfen eine Oxiddeckschicht (5) aufgebracht wird, wobei die Oxiddeckschicht Aluminiumoxid umfasst und das Aluminiumoxid zumindest teilweise als freies α - Al₂O₃ vorliegt und die Oxiddeckschicht (5) mindestens 50 vol.-% α - Al₂O₃ umfasst, wobei die Oxiddeckschicht (5) weiterhin Lanthan beinhaltet, wobei nach dem Aufbringen der Oxiddeckschicht (5) das Wärmedämmschichtsystem (2) einer Wärmebehandlung unterzogen wird, sodass in der Oxiddeckschicht freies α - Al₂O₃ vorliegt und die Oxiddeckschicht (5) eine Porosität von 5 bis 30 vol.-% aufweist.

7. Verfahren nach Anspruch 6,
**dadurch gekennzeichnet, dass**
Abscheideparameter der Oxiddeckschicht (5) so gewählt werden, dass eine Porosität der Oxiddeckschicht im Bereich von 10 vol.-% bis 25 vol.-% eingestellt wird.

## Claims

1. Component of a turbomachine comprising a thermal barrier coating system having a ceramic coating (4) made of fully or partially stabilized zirconium oxide and an oxide cover coating (5) on the ceramic coating (4), the oxide cover coating comprising aluminum oxide, the aluminum oxide at least partially being present as free α-Al₂O₃ and the oxide cover coating (5) comprising at least 50 vol.% of the α-Al₂O₃ and an oxide coating system (4, 5) comprising the thermal barrier coating (4) made of zirconium oxide and the oxide cover coating (5),
**characterized in that**
the oxide cover coating (5) further includes lanthanum and the oxide cover coating (5) has a porosity of 5 to 30 vol%.

2. Component according to claim 1,
**characterized in that**
the oxide cover coating (5) comprises at least 60 vol%, in particular at least 90 vol% of the α-Al₂O₃.

3. Component according to either of the preceding claims,
**characterized in that**
the oxide cover coating (5) has a porosity of 10 to 25 vol%.

4. Component according to any of the preceding claims,
**characterized in that**
the thermal barrier coating system (2) has an adhesion promoter coating and/or oxidation protection coating (3) on the side of the ceramic coating (4) facing away from the oxide cover coating (5).

5. Component according to any of the preceding claims,
**characterized in that**
the oxide coating system (4, 5) has a coating thickness of at most 750 µm, preferably at most 500 µm, in particular the oxide cover coating (5) having a thickness in the range of 50 µm to 250 µm.

6. Method for producing a thermal barrier coating system on a component of a turbomachine, in which method a ceramic coating (4) made of fully or partially stabilized zirconium oxide is applied to a substrate (1) or an adhesion promoter coating (3) by means of thermal spraying or electron beam evaporation, wherein an oxide cover coating (5) is subsequently applied to the ceramic coating (4) by means of thermal spraying or electron beam evaporation, wherein the oxide cover coating comprises aluminum oxide and the aluminum oxide is at least partially present as free α-Al₂O₃ and the oxide cover coating (5) comprises at least 50 vol% of the α-Al₂O₃, wherein the oxide cover coating (5) further includes lanthanum, wherein after the oxide cover coating (5) has been applied, the thermal barrier coating system (2) is subjected to a heat treatment such that free α-Al₂O₃ is present in the oxide cover coating and the oxide cover coating (5) has a porosity of 5 to 30 vol%.

7. Method according to claim 6,
**characterized in that**
deposition parameters of the oxide cover coating (5) are selected such that a porosity of the oxide cover coating is adjusted in the range of 10 vol% to 25 vol%.

## Revendications

1. Composant d'une turbomachine comportant un système de couches calorifuges comportant une couche de céramique (4) composée d'oxyde de zirconium entièrement ou partiellement stabilisé et une couche supérieure d'oxyde (5) sur la couche de céramique (4), la couche supérieure d'oxyde comprenant de l'alumine, l'alumine étant présente au moins partiellement sous forme d'α-Al₂O₃ libre et la couche supérieure d'oxyde (5) comprenant au moins 50 % en volume d'α-Al₂O₃ et un système de couches d'oxyde (4, 5) comprenant la couche calorifuge (4) en oxyde de zirconium et la couche supérieure d'oxyde (5),
**caractérisé en ce que**
la couche supérieure d'oxyde (5) contient en outre du lanthane et la couche supérieure d'oxyde (5) présente une porosité de 5 à 30 % en volume.

2. Composant selon la revendication 1,
**caractérisé en ce que**
la couche supérieure d'oxyde (5) comprend au moins 60 % en volume, en particulier au moins 90 % en volume, d'α-Al₂O₃.

3. Composant selon l'une des revendications précédentes,
**caractérisé en ce que**
la couche supérieure d'oxyde (5) présente une porosité de 10 à 25 % en volume.

4. Composant selon l'une des revendications précédentes,
**caractérisé en ce que**
le système de couches calorifuges (2) présente, sur le côté de la couche de céramique (4) opposé à la couche supérieure d'oxyde (5), une couche de promoteur d'adhérence et/ou de protection contre l'oxydation (3).

5. Composant selon l'une des revendications précédentes,
**caractérisé en ce que**
le système de couches d'oxyde (4, 5) présente une épaisseur de couche d'au maximum 750 µm, de préférence d'au maximum 500 µm, la couche supérieure d'oxyde (5) présentant en particulier une épaisseur dans la plage de 50 µm à 250 µm.

6. Procédé pour la production d'un système de couches calorifuges sur un composant d'une turbomachine, dans lequel une couche de céramique (4) composée d'oxyde de zirconium entièrement ou partiellement stabilisé est appliquée au moyen d'une pulvérisation thermique ou d'une évaporation par faisceau d'électrons sur un substrat (1) ou une couche de promoteur d'adhérence (3), une couche supérieure d'oxyde (5) étant ensuite appliquée sur la couche de céramique (4) au moyen d'une pulvérisation thermique ou d'une évaporation par faisceau d'électrons, la couche supérieure d'oxyde comprenant de l'alumine et l'alumine étant présente au moins partiellement sous forme d'α-Al₂O₃ libre et la couche supérieure d'oxyde (5) comprenant au moins 50 % en volume d'α-Al₂O₃, la couche supérieure d'oxyde (5) contenant en outre du lanthane, après l'application de la couche supérieure d'oxyde (5), le système de couches calorifuges (2) étant soumis à un traitement thermique, de telle sorte que de l'α-Al₂O₃ libre est présente dans la couche supérieure d'oxyde et que la couche supérieure d'oxyde (5) présente une porosité de 5 à 30 % en volume.

7. Procédé selon la revendication 6,
**caractérisé en ce que**
les paramètres de dépôt de la couche supérieure d'oxyde (5) sont choisis de telle sorte qu'une porosité de la couche supérieure d'oxyde est réglée dans la plage de 10 % en volume à 25 % en volume.
